# EUROPEAN PATENT SPECIFICATION

(11) **EP 3 809 809 B1**
(45) Date of publication and mention of the grant of the patent: **16.08.2023**
(21) Application number: 18922495.9
(22) Date of filing: 12.06.2018
(51) Int. Cl.: H05K 13/08, H05K 13/02

(54) **EXCHANGE DEVICE**
WECHSELVORRICHTUNG
DISPOSITIF D'ÉCHANGE

(43) Date of publication of application: 21.04.2021
(73) Proprietor: Fuji Corporation, Chiryu-shi, Aichi 472-8686 (JP)
(72) Inventor: KONDO Masahiro, Chiryu-shi, Aichi 472-8686 (JP); TANAKA Keita, Chiryu-shi, Aichi 472-8686 (JP)
(74) Representative: Grünecker Patent- und Rechtsanwälte PartG mbB
(86) International application number: PCT/JP2018/022363
(87) International publication number: WO 2019/239474

(56) References cited:
- WO-A1-2015/121976
- JP-A- H0 329 400
- JP-A- H08 222 891
- JP-A- H10 249 650
- JP-A- 2009 094 234
- JP-A- 2017 216 379
- US-A1- 2017 172 021
- US-A1- 2017 303 448

## Description

### TECHNICAL FIELD

The present description relates to an exchange device for automatically exchanging an exchangeable element detachably installed in a component mounting device.

### BACKGROUND ART

Technology for mass producing circuit boards by applying board work to boards on which wiring is printed is widespread. Board work devices for performing board work include a component mounting device for performing component mounting work. As a typical example of a component supply device provided in a component mounting device, there is a tape feeder for supplying components using a carrier tape. In recent years, in order to save labor in supplying components, technology for automatically exchanging tape feeders or automatically exchanging tape reels on which carrier tapes are wound have been developed. Technological examples relating to this type of exchange device are disclosed in Patent Literature 1 and 2.

The feeder exchange device of Patent Literature 1 includes a feeder accommodation section accommodating multiple tape feeders; a moving member moving between the feeder accommodation section and a feeder table of the component mounting device; a gripping device, being provided to the moving member, which grips the tape feeders, and one of element of a cutting device cutting the cover tape peeled from carrier tapes. With this, automatic exchanging of tape feeders becomes possible, and the load on operators is greatly reduced. Furthermore, according to the description of the embodiment, the feeder exchange device includes, in addition to an actuator (i.e., a driving section) for the gripping device, a second actuator for releasing a clamping mechanism which locks tape feeders to the feeder table.

The component mounting system of Patent Literature 2 includes a component mounting device for mounting a component on a board; a component supply device, for supplying components, installed in the component mounting device; and a self-propelled component replenishing device for automatically moving with holding a component container and for replenishing components to the component supply device. With this, component exchanging work of the operator can be reduced. Further, according to the description of the embodiment, the self-propelled component replenishing device includes a cassette replenishing mechanism, for replenishing component cassettes which serve as component containers, and a cassette collection mechanism, for collecting the component cassettes. In other words, the self-propelled component replenishing device includes separate driving sections for replenishing and collecting component cassettes. Further examples of component mounting devices are known from JP 2009094234 and US 2017/172021 A1.

### PATENT LITERATURE

Patent Literature 1: WO 2015/121976
Patent Literature 2: JP-A-2017-216379

### SUMMARY OF THE INVENTION

### Technical Problem

In the technological examples of the exchange devices of Patent Literature 1 and 2, multiple driving sections are used for exchanging exchangeable elements (tape feeders, component cassettes). However, the use of multiple driving sections increases the cost of the exchange device. In addition, there arise constraints on the arrangement space for multiple driving sections, problems involved with increasing the size of the device, and the like. In particular, in recent years, in response to a demand to miniaturize components and increase the number of component types that can be supplied, the tape feeder has been made thinner and it has become necessary to make the exchange device more compact.

It is an object of the present invention to solve the problem of providing a low-cost exchange device by simplifying the driving section.

### SOLUTION TO PROBLEM

The invention is defined by the features of claim 1. Further embodiments are defined in the dependent claims.

### Advantageous Effect of the Invention

With the exchange device disclosed in this specification, since the holding mechanism and the release mechanism are driven by a shared driving section, the number of constituent components is reduced compared to the conventional case as the driving source is shared, making it possible to simplify the configuration of the driving section. Therefore, compared with the prior art in which separate driving sections are provided for the holding mechanism and the release mechanism, a low-cost exchange device can be provided.

### BRIEF DESCRIPTION OF DRAWINGS

Fig. 1 is a perspective view showing a configuration example of a component mounting system in which an exchange device of the embodiment is applied.
Fig. 2 is a side view of a tape feeder serving as an exchangeable element.
Fig. 3 is a side view showing a configuration in the vicinity of a lock section of the tape feeder and the internal configuration of an attachment/detachment directional moving section.
Fig. 4 is a perspective view showing an internal configuration of an exchange section.
Fig. 5 is a side view of the attachment/detachment directional moving section showing a holding state in which a holding mechanism and a release mechanism operate.
Fig. 6 is a perspective view showing a state in which the exchange section accommodates a tape feeder.

### DESCRIPTION OF EMBODIMENTS

### 1. Configuration of component mounting system 9 in which exchange device 1 of the embodiment is applied

First, a configuration example of component mounting system 9, which is the application portion of exchange device 1 of the embodiment, will be described.

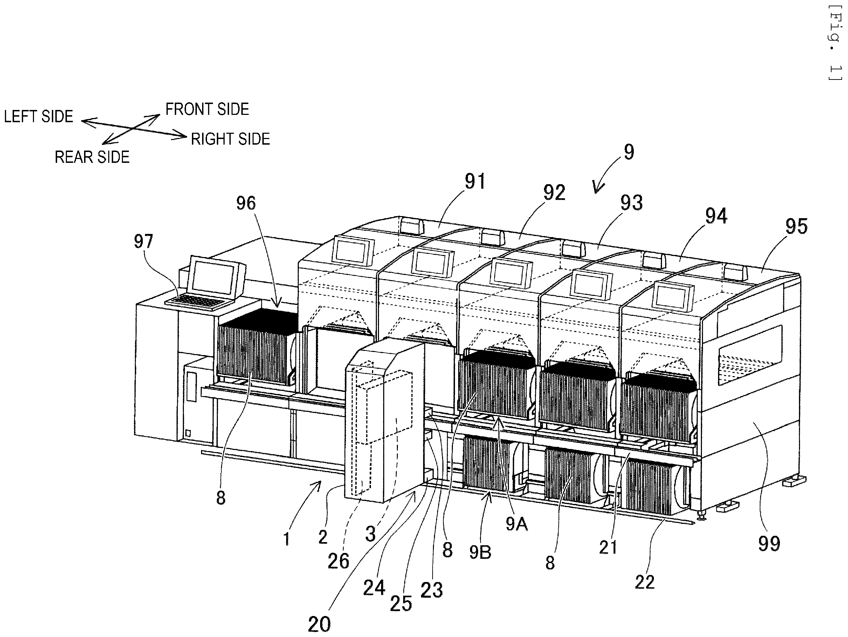

Fig. 1 is a perspective view showing a configuration example of component mounting system 9 in which exchange device 1 of the embodiment is applied. The front, rear, left, and right of the component mounting system 9 will be defined as shown in Fig. 1 for convenience. Component mounting system 9 is configured by arranging multiple board work devices in the left-right direction. That is, solder printing device 91, print inspection device 92, first component mounting device 93, second component mounting device 94, third component mounting device 95, a board appearance inspection device (not shown), and a reflow device (not shown) are arranged in a row from the left side to the right side.

Each board work device performs a predetermined operation on a board, that is, a board operation. Specifically, solder printing device 91 prints paste-like solder on a board in a defined pattern shape. Print inspection device 92 images and inspects the solder printing state of a board. First component mounting device 93, second component mounting device 94, and third component mounting device 95 picks up components from component supply section 9A and mount the components on the solder of a board. The board appearance inspection device images components mounted on the board and inspects the appearance. The reflow device ensures soldering of components by heating and cooling the solder. Board work is not limited to the above-described work content and includes accompanying work and the like. For example, board convey-in/out operations, positioning operations, and checking operations, for determining positions and orientations of boards and components by imaging boards and components, are also included in board work.

First component mounting device 93, second component mounting device 94, and third component mounting device 95 have the same structure. Component mounting devices 93,94,95 each include component supply section 9A, spare feeder storage section 9B, a board conveyance device not visible in Fig. 1, and a component transfer device.

Component supply section 9A is disposed at an intermediate height of the front side of device table 99. Component supply section 9A has multiple slots extending in the front-rear direction and formed parallel with each other at a predetermined pitch. Tape feeder 8 is inserted into each slot of component supply section 9A. That is, multiple tape feeders 8 are arranged side by side in the left-right direction of Fig. 1.

Tape feeder 8 is a component supply device detachably installed in component supply section 9A and serves as an exchangeable element. In addition, the left-right direction in Fig. 1 is the arrangement direction of the exchangeable element (hereinafter, simply referred to as the arrangement direction), and the front-rear direction in Fig. 1 is the attachment/detachment direction of the exchangeable element (hereinafter, simply referred to as the attachment/detachment direction). Tape feeder 8 is used interchangeably in first component mounting device 93, second component mounting device 94, and third component mounting device 95.

Spare feeder storage section 9B is disposed below component supply section 9A on the front side of device table 99. Spare feeder storage section 9B also has multiple slots extending in the front-rear direction and formed parallel to each other at a predetermined pitch. In the slots of spare feeder storage section 9B, spare tape feeders 8 ready for use and used tape feeders 8 are arranged and temporarily stored. The board conveyance device carries in, positions, and carries out boards. The component transfer device picks up a component from component supply section 9A using a component mounting tool, such as a suction nozzle, and mounts the component on a board.

Further, component mounting system 9 is provided with feeder storage device 96, line management device 97, and exchange device 1 of the embodiment. Feeder storage device 96 is disposed adjacent to the left side of solder printing device 91 and at the same height as component supply section 9A of component mounting devices 93, 94, 95. Feeder storage device 96 also has multiple slots extending in the front-rear direction and formed parallel to each other at a predetermined pitch. Also, in the slots of feeder storage device 96, tape feeders 8 ready for use and used tape feeders 8 are arranged and stored.

Line management device 97 is disposed adjacent to the left side of feeder storage device 96. Line management device 97 is connected in communication with multiple board work devices. Line management device 97 manages job data describing work contents of board operations which are different for each board type. Line management device 97 transmits job data to multiple board work devices based on a production plan. Line management device 97 further monitors operation states of multiple board work devices.

### 2. Structure of tape feeder 8

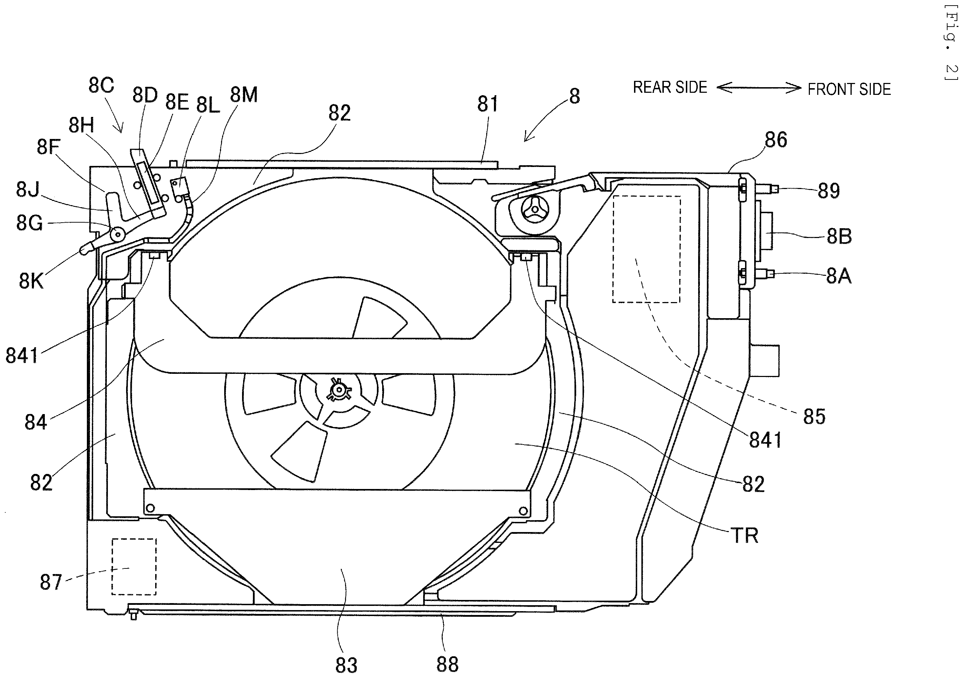

Next, the structure of tape feeder 8 will be described. Fig. 2 is a side view of tape feeder 8 which serves as an exchangeable element. Tape feeder 8 is configured to be thin in the width direction by assembling various members to a frame body 81 including a side plate. Tape feeder 8 includes frame body 81, reel accommodation frame 82, accommodation plate 83, open/close plate 84, tape feeding section 85, component supply position 86, feeder control section 87, protruding strip 88, upper positioning pin 89, lower positioning pin 8A, connector 8B, lock section 8C, and the like.

Reel accommodation frame 82 is a multiple of frame members that form a large circular internal space substantially at the center of frame body 81. Reel accommodation frame 82 accommodates tape reel TR in an internal space so that tape reel TR can freely rotate. Accommodation plate 83 is attached to the lower portion of reel accommodation frame 82. The separation distance between accommodation plate 83 and the side plate of frame body 81 is set slightly larger than the thickness of tape reel TR. Accommodation plate 83 prevents tape reel TR from becoming detached.

Open/close plate 84 is attached above the intermediate height of reel accommodation frame 82. The separation distance between open/close plate 84 and the side plate of frame 81 is also set slightly larger than the thickness of tape reel TR. In addition, open/close plate 84 is configured such that two front and rear upper portions 841 are supported by frame body 81 and open upward. By opening open/close plate 84, tape reel TR can be exchanged. A carrier tape, in which multiple components are stored, is wound around tape reel TR. Tape reel TR serves as a component container for accommodating multiple components.

Tape feeding section 85 is disposed at the front upper portion of frame body 81. Tape feeding section 85 draws out the carrier tape from tape reel TR and feeds the carrier tape to component supply position 86 provided at the front of the top face of frame body 81. Tape feeding section 85 is composed of a sprocket having teeth that fit into the feeding holes of the carrier tape, a motor that drives the sprocket in a rotational manner, and the like.

Feeder control section 87 is disposed at the rear lower portion of frame body 81. Feeder control section 87 controls tape feeding section 85 and monitors the state of lock section 8C. Feeder control section 87 is connected in communication with the control device on the main body side of component mounting device 93,94,95 via connector 8B.

Protruding strip 88 is provided on the bottom face of frame body 81. Protruding strip 88 is inserted into any of the slots of component supply section 9A, spare feeder storage section 9B, and feeder storage device 96. Protruding strip 88 is also inserted into slot 314 of case 31 of exchange section 3 of exchange device 1, which will be described later. As a result, protruding strip 88 is guided by slot 314 at the time of exchanging, and tape feeder 8 moves from exchange device 1 to component supply section 9A or the like or moves in the reverse direction.

Upper positioning pin 89 and lower positioning pin 8A are provided at the upper portion of the front face of frame body 81 so as to be separated from each other in the up-down direction. Upper positioning pin 89 and lower positioning pin 8A fit into the positioning holes of component supply section 9A to position tape feeder 8. Connector 8B is disposed between upper positioning pin 89 and lower positioning pin 8A. Connector 8B is responsible for supplying power and providing a communication connection to tape feeder 8. When tape feeder 8 is positioned, connector 8B automatically fits into the receiving side connector of component supply section 9A.

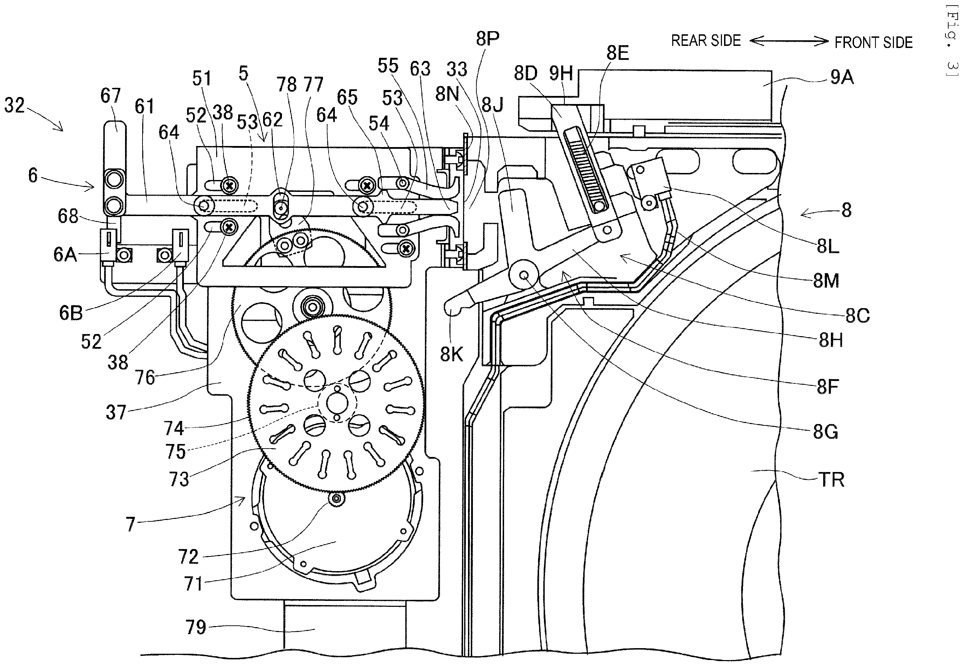

Lock section 8C is disposed at the rear upper portion of frame body 81. Fig. 3 is a side view showing a configuration of the lock section vicinity of lock section 8C of tape feeder 8 and the internal configuration of attachment/detachment directional moving section 32 of exchange device 1, which will be described later. Lock section 8C includes lock pin 8D, lock spring 8E, lock operation member 8F, lock sensor 8L, and the like. Lock pin 8D is a tubular member and is held by frame body 81 in a manner which allows vertical movement. Lock spring 8E has a coil shape and is arranged inside lock pin 8D. One end of lock spring 8E is coupled to frame body 81, and the other end thereof is coupled to lock pin 8D.

Lock spring 8E biases lock pin 8D upward. In tape feeder 8 installed in component supply section 9A, lock pin 8D lifted up by the biasing protrudes from the top face of frame body 81 and fits into lock hole 9H of component supply section 9A. As a result, lock section 8C is brought into a locked state, and tape feeder 8 is prevented from coming out or rattling.

Lock operation member 8F is a Y-shaped member having swing fulcrum 8G. Swing fulcrum 8G is supported by frame body 81 in a manner which allows swinging. Operation arm 8H extending forward from swing fulcrum 8G engages with the lower end of lock pin 8D. Release arm 8J extending upward from swing fulcrum 8G is pushed forward by direct operation member 61 described later. Manual arm 8K extending rearward from swing fulcrum 8G protrudes from the rear face of frame body 81. Manual arm 8K is pushed upward by the operation of an operator.

When release arm 8J or manual arm 8K is pushed and moved, lock operation member 8F swings clockwise in Fig. 2 about swing fulcrum 8G. When this occurs, operation arm 8H lowers lock pin 8D against the force of lock spring 8E. Lock pin 8D then escapes from lock hole 9H. As a result, lock section 8C shifts from a locked state to a released state, as shown in Fig. 8. In addition, tape feeder 8 is in a state in which it is possible to draw out tape feeder 8 from the slot.

Lock sensor 8L detects the state of lock section 8C, that is, whether lock section 8C is in the locked state or the released state. Lock sensor 8L outputs the detection result to feeder control section 87 via output cable 8M. In tape feeder 8 installed in component supply section 9A, feeder control section 87 does not proceed with the supplying of components when lock section 8C is in the released state. The reason is that it is determined that tape feeder 8 is not in a good installation orientation.

Further, as shown in Fig. 3, holding plate 8N is provided in the vertical direction on the rear side of lock section 8C. Holding plate 8N is a part held by holding mechanism 5. Holding plate 8N has holding hole 8P at its center. Holding hole 8P is positioned at the same height as that of connector 8B. When viewed from the rear, release arm 8J of lock operation member 8F is positioned on the extension line of holding hole 8P.

### 3. Configuration of exchange device 1 of the embodiment

Next, a description will be given of exchange device 1 of the embodiment. Exchange device 1 automatically exchanges tape feeder 8. Specifically, exchange device 1 exchanges tape feeder 8 between component supply section 9A and spare feeder storage section 9B of component mounting device 93,94,95. Further, exchange device 1 moves between component mounting devices 93,94,95 and feeder storage device 96, and conveys and exchanges tape feeder 8.

As shown in Fig. 1, exchange device 1 includes arrangement directional moving section 2, arrangement direction driving device 20, exchange section 3, and various constituent elements provided inside exchange section 3. Arrangement directional moving section 2 is provided in a manner which allows movement in the arrangement direction with respect to component mounting devices 93, 94, 95. Arrangement directional moving section 2 is an oblong box-shaped member having an open front side. Arrangement direction driving device 20 moves arrangement directional moving section 2 in the arrangement direction. Arrangement direction driving device 20 is configured with a track section provided on the non-moving side; an engaging section, engaged with the track section in a movable manner, provided on the moving side; a driving source for generating moving power; and the like.

Middle rail 21 and lower rail 22 constituting the track section are provided on the rear face of device table 99 at each of the multiple board work devices and on the rear face of feeder storage device 96. Middle rail 21 and lower rail 22 extend in the arrangement direction. The height of middle rail 21 is integrated between component supply section 9A and spare feeder storage section 9B. The height of lower rail 22 is integrated with the lower side of spare feeder storage section 9B. As a result, the multiple middle rails 21 and the multiple lower rails 22 form two tracks which are parallel to each other and continue from feeder storage device 96 to third component mounting device 95.

Middle-level traveling section 23 and lower-level traveling section 24, serving as engaging sections, are arranged on the left and right on the front side of arrangement-directional moving section 2. Middle-level traveling section 23 is engaged with middle-level rail 21 in a movable manner, and lower-level traveling section 24 is engaged with lower-level rail 22 in a movable manner. Middle-level traveling section 23 further includes a driving source for generating traveling power. As a result, arrangement directional moving section 2 attaches to middle rail 21 and lower rail 22, and travels and moves in the arrangement direction.

Furthermore, arrangement directional moving section 2 includes a non-contact power receiving section 25 at a height between middle-level traveling section 23 and lower-level traveling section 24, which is a height that does not hinder exchange of tape feeder 8. Non-contact power receiving section 25 receives power in a non-contact manner from non-contact power transmission sections provided at a corresponding height on the multiple board work devices.

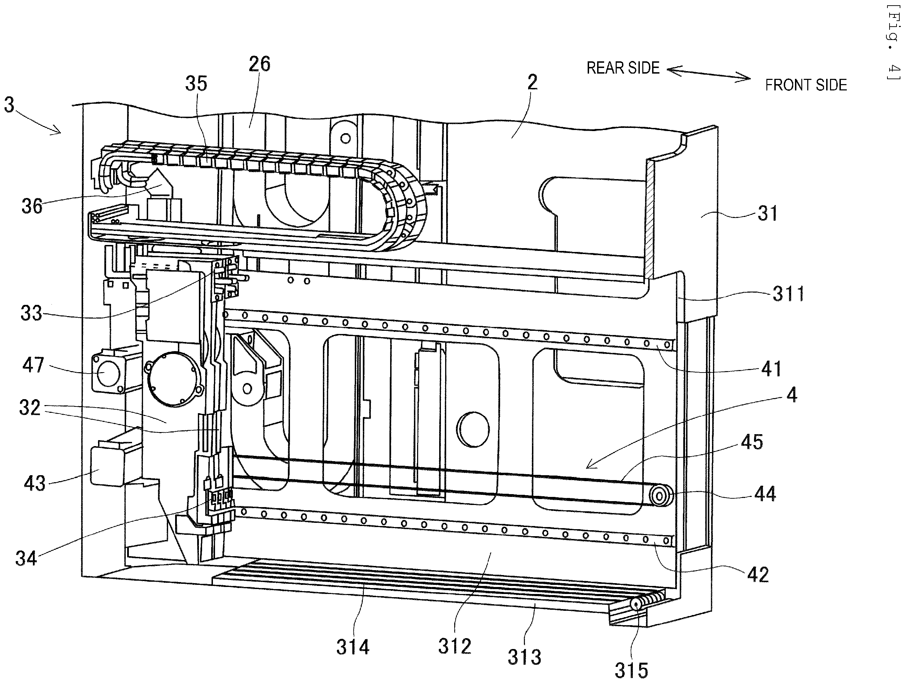

Further, arrangement directional moving section 2 has lifting/lowering driving section 26 and exchange section 3 inside a box-shaped interior space. Lifting/lowering driving section 26 lifts and lowers exchange section 3 from the height of component supply section 9A to the height of spare feeder storage section 9B. A ball screw feed mechanism is an example of lifting/lowering driving section 26, but the present invention is not limited thereto but to the limits of the appended claims. Fig. 4 is a perspective view showing the internal configuration of exchange section 3. In Fig. 4, the side plate and the like of case 31 closer to the viewer from the viewpoint of the figure, are omitted.

Exchange section 3 includes case 31, two attachment/detachment directional moving sections 32, and two attachment/detachment direction driving devices 4. Case 31 has opening 311 on the front side through which four tape feeders 8 arranged adjacent to each other can be ejected out or taken in while the four tape feeders 8 lined up side by side. Case 31 further has an internal space in which four tape feeders 8 can be accommodated. Four slots 314 in parallel with each other at a predetermined pitch are engraved in bottom plate 313 of case 31. Further, guide rollers 315 are disposed in the front of each slot 314 of bottom plate 313. As a result, tape feeder 8 is ejected out or taken in by way of opening 311 and guide roller 315 while protruding strip 88 is guided by slot 314.

The two attachment/detachment directional moving sections 32 are provided in a manner which allows movement, independently of each other, in the attachment/detachment direction, with respect to arrangement directional moving section 2. The two attachment/detachment directional moving sections 32 are provided in case 31 and arranged separately in the arrangement direction. Attachment/detachment directional moving section 32 has holding face 33 at the upper portion of the front side and abutting face 34 at the lower portion of the front side. Attachment/detachment directional moving section 32 holds holding plate 8N on the rear face upper portion of tape feeder 8 with holding face 33. When this occurs, abutting face 34 abuts the lower rear face portion of tape feeder 8. It is also possible to provide a connector on abutting face 34 and connect abutting face 34 to feeder control section 87 of tape feeder 8.

In order to supply power to attachment/detachment directional moving section 32, which moves, flexible power cable 35 is put in on the top side of attachment/detachment directional moving section 32. Power cable 35 is connected to power supply terminal 36 at an upper portion of attachment/detachment directional moving section 32.

Attachment/detachment direction driving devices 4 move the two attachment/detachment directional moving sections 32 independently in the attachment/detachment direction. Attachment/detachment direction driving device 4 is provided for each attachment/detachment directional moving section 32. Attachment/detachment direction driving device 4 includes upper rail 41, lower rail 42, driving motor 43, fixed pulley 44, drive belt 45, and the like. Fig. 3 shows attachment/detachment direction driving device 4 that drives attachment/detachment directional moving section 32 which is toward the back in the paper.

Upper rail 41 and lower rail 42 are provided on side plate 312 of case 31. Upper rail 41 and lower rail 42 are parallel to each other, while being vertically separated from each other, and extend in the attachment/detachment direction. Driving motor 43 is disposed at the rear of case 31. A deceleration mechanism is attached to an output shaft protruding from driving motor 43 toward the back side in the drawing. Fixed pulley 44 is disposed in the front portion of side plate 312. Annular drive belt 45 is horizontally bridged between the output section of the deceleration mechanism and fixed pulley 44, and is capable of rotating.

Attachment/detachment directional moving section 32 is installed on upper rail 41 and lower rail 42. Attachment/detachment directional moving section 32 is driven by rotation of drive belt 45 and moves the internal space of exchange section 3 in the attachment/detachment direction. Attachment/detachment direction driving device 4 moves tape feeder 8 together with attachment/detachment directional moving section 32 held by holding face 33. Naturally, attachment/detachment direction driving device 4 can also move attachment/detachment directional moving section 32 alone.

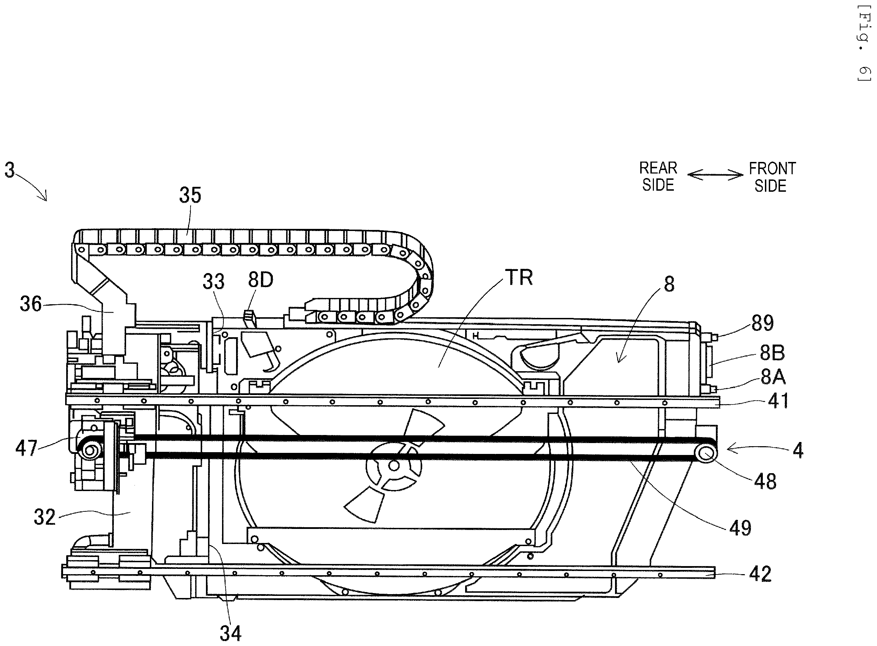

With respect to attachment/detachment direction driving device 4 that drives attachment/detachment directional moving section 32 on the front side of the drawing, the configuration itself is the same as that described above, but the arrangement positions of the members are different. That is, driving motor 47 is provided at a higher position than driving motor 43 in the reverse direction. In addition, as shown in Fig. 6, fixed pulley 48 and drive belt 49 which are provided on the side plate (not shown) on the front side of the drawing are also arranged at correspondingly high positions. By arranging two attachment/detachment direction driving devices 4 in opposite directions at different heights in this manner, thinning of exchange section 3 and arrangement directional moving section 2 is made possible.

The internal configuration of attachment/detachment directional moving section 32 will be further described. Two sets of holding mechanisms 5, release mechanisms 6, shared driving sections 7, and control sections 79 are provided in each of two attachment/detachment directional moving sections 32. These two sets have the same configuration, are arranged side by side in the arrangement direction, and operate independently of each other. Hereinafter, the configuration of one set will be described in detail. Holding mechanism 5, release mechanism 6, shared driving section 7, and control section 79 are attached to main body section 37 which is a part of attachment/ detachment directional moving section 32 and extends in the vertical direction.

Shared driving section 7 operates holding mechanism 5 and release mechanism 6. As shown in Fig. 3, shared driving section 7 includes stepping motor 71, first gear 73, second gear 76, and swing member 77. Stepping motor 71 is fixed to the lower portion of main body section 37. Stepping motor 71 switches between normal rotation and reverse rotation in accordance with instructions from control section 79, and rotates by the instructed rotation amount. The output shaft of stepping motor 71 is provided with output gear 72 having a small number of teeth.

First gear 73 is disposed above stepping motor 71 and supported by main body section 37 in a manner which allows rotation. First gear 73 is configured such that large gear 74 having a relatively large number of teeth and small gear 75 having a relatively small number of teeth are integrally superposed coaxially. In Fig. 4, small gear 75 is not visible being positioned behind large gear 74. Large gear 74 meshes with output gear 72.

Second gear 76 is disposed above first gear 73 and supported by main body section 37 in a manner which allows rotation. Second gear 76 has a larger number of teeth than small gear 75 and meshes with small gear 75. Swing member 77 is provided near the upper portion of second gear 76. Swing member 77 has swing pin 78 at a position outside the outer circumference of second gear 76. Output gear 72, first gear 73, and second gear 76 constitute the deceleration mechanism. With this configuration, the forward rotation and the reverse rotation of stepping motor 71 are converted into the swinging of swing pin 78 in the attachment/detachment direction.

Release mechanism 6 is capable of releasing lock section 8C which prevents tape feeder 8 installed in component supply section 9A from becoming detached. Release mechanism 6 includes direct operation member 61, manual lever 67, and the like. Direct operation member 61 is a rod-like member long in the attachment/detachment direction. Direct operation member 61 has long hole 62 which is long in the up-down direction at a substantially intermediate position in the longitudinal direction. Swing pin 78 is loosely fitted in long hole 62. Therefore, the swinging of swing pin 78 in a circular arc is directly converted into linear movement of direct operation member 61 in the attachment/detachment direction. Direct operation member 61 has, at the front end, release operation portion 63 for releasing lock section 8C.

Further, direct operation member 61 has intermediate driving pins 64 to the front and to the rear of long hole 62 such that long hole 62 is interposed in between the intermediate driving pins 64. The two intermediate driving pins 64 are loosely fitted into long holes 53 of slide plate 51, which will be described later. Thus, the horizontal state of direct operation member 61 is maintained. Intermediate driving pins 64 serve as intermediate driving portions that operate holding mechanism 5 in the attachment/detachment direction. Further, direct operation member 61 has indirect driving protrusions 65 on the upper and lower side faces, between the front-side intermediate drive pin 64 and release operation portion 63. The pair of upper and lower indirect driving protrusions 65 drive chuck 55 of holding mechanism 5, which will be described later. Indirect driving protrusions 65 serve as indirect driving portions that operate the indirect operation member (chuck 55) of holding mechanism 5.

Manual lever 67 is erected directly upward from the rear end of direct operation member 61. Manual lever 67 is operated in the attachment/detachment direction by the operator and enables manual operation of operation member 61 directly when shared driving section 7 malfunctions or the like. Position marker 68 is provided below manual lever 67. Position marker 68 operates integrally with direct operation member 61 to indicate the position of direct operation member 61. Main body section 37 is provided with reference position sensor 6A and holding position sensor 6B for detecting position marker 68.

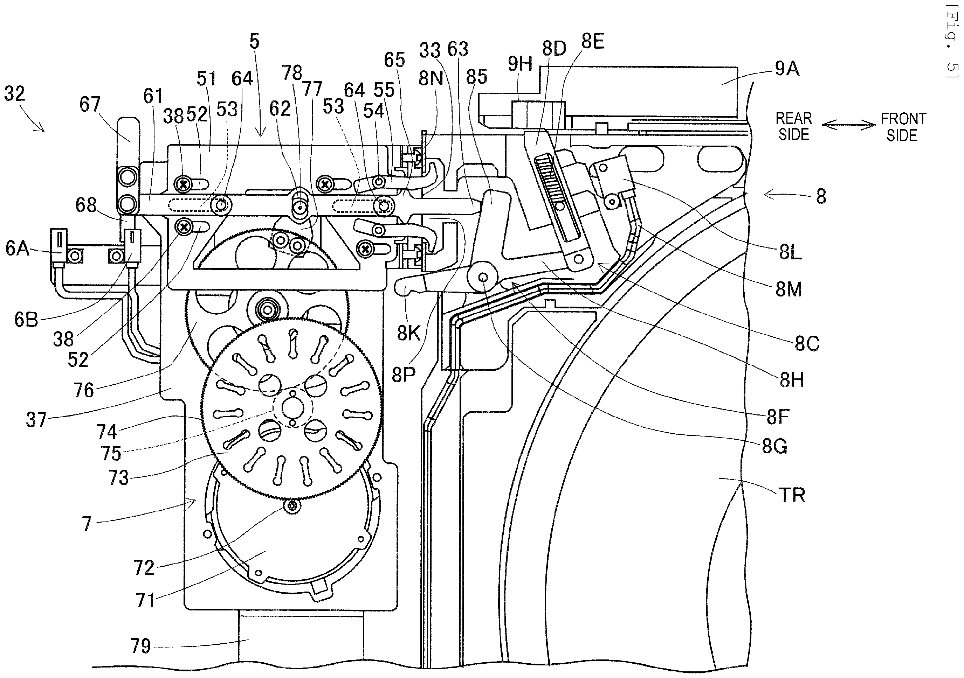

Fig. 3 shows an initial state in which holding mechanism 5 and release mechanism 6 are not operating. Reference position sensor 6A detects position marker 68 at the rear end position of direct operation member 61 corresponding to the initial state. Holding position sensor 6B detects position marker 68 at the front end position of direct operation member 61 corresponding to the holding state when holding mechanism 5 and release mechanism 6 operate, as shown in Fig. 5. Reference position sensor 6A and holding position sensor 6B output detection results to control section 79.

Holding mechanism 5 is capable of holding tape feeder 8 which is targeted for exchange. The two holding mechanisms 5 share holding face 33. Each holding mechanism 5 includes slide plate 51, a pair of upper and lower chucks 55, and the like. Slide plate 51 is a substantially rectangular plate-like member, and has a trapezoidal cutout hole. Slide plate 51 is biased toward the front by a biasing spring (not shown). Swing member 77 swings in the cutout hole of slide plate 51. Four elongated slide holes 52 long in the attachment/detachment direction are formed in slide plate 51. Each of slide holes 52 is loosely fitted with support pin 38 erected on main body section 37. Two long holes 53 long in the attachment/detachment direction are formed in slide plate 51. Each of long holes 53 is loosely fitted with intermediate driving pin 64.

The dimensional allowance in the attachment/detachment direction of long hole 53 is larger than the dimensional allowance in the attachment/detachment direction of slide hole 52. When the dimensional allowance in the attachment/detachment direction of slide hole 52 and the dimensional allowance in the attachment/detachment direction of long hole 53 are added, direct operation member 61 matches the predetermined operation stroke length which operates in the attachment/detachment direction. In the initial state shown in Fig. 3, intermediate driving pin 64 is in contact with the rear edge of long hole 53 and prevents slide plate 51 biased toward the front from advancing. At this juncture, slide plate 51 is in a retracted position in which support pin 38 contacts the front edge of slide hole 52.

Chuck bearing seats 54 are provided at two points, near the front of slide plate 51, which are directly symmetrical in the up-down direction with respect to direct operation member 61. The pair of upper and lower chucks 55 are supported by chuck bearing seats 54 in a manner which allows swinging. Chuck 55 serves as an indirect operation member. The upper and lower pair of chucks 55 have parallel portions whose rear sides are substantially parallel to each other, proximal portions where the front sides of the parallel portions approach each other, and bent portions where the front sides of the proximate portions bend away from each other. Chuck 55 is supported around the boundary between the parallel portions and the proximal portions.

Indirect driving protrusions 65 of direct operation member 61 slide against oppositely facing surfaces of upper and lower chucks 55, respectively. In Fig. 3, indirect driving protrusions 65 slide against the tail ends of the parallel portions of chuck 55. At this juncture, the upper and lower pair of chucks 55 are in a closed state in which the proximal portions are in direct contact with direct operation member 61. While sandwiching release operation portion 63 of direct operation member 61, the bent portions of the pair of upper and lower chucks 55 are closed smaller than holding hole 8P of tape feeder 8.

Control section 79 is disposed below main body section 37. Control section 79 controls the rotation direction and the rotation amount of stepping motor 71 based on detection results from reference position sensor 6A and holding position sensor 6B. Since the rotation amount of stepping motor 71 is controllable, reference position sensor 6A and holding position sensor 6B are not essential. However, when the supply of power to exchange device 1 is stopped or when an operation is performed by manual lever 67, there is a possibility that the position of operation member 61 will not be known. Therefore, it is preferable to provide at least one of reference position sensor 6A and holding position sensor 6B.

### 4. Operation of exchange device 1 of the embodiment

Next, the holding operation in which exchange device 1 of the embodiment holds tape feeder 8 will be described in detail. The following description is common regardless of where tape feeder 8 to be held is located in feeder storage device 96, component supply section 9A, and spare feeder storage section 9B. First, arrangement direction driving device 20 moves arrangement directional moving section 2 to the front face of tape feeder 8 which is targeted for holding. Next, lifting/lowering driving section 26 adjusts the height of exchange section 3 in accordance with tape feeder 8. Next, attachment/detachment direction driving device 4 advances attachment/detachment directional moving section 32 facing tape feeder 8 in the attachment/detachment direction. Attachment/detachment directional moving section 32 advances until holding face 33 comes into contact with holding plate 8N of tape feeder 8. At this point, the state shown in Fig. 3 is reached.

As shown in Fig. 3, in the initial state, in which operation does not occur, holding mechanism 5 and release mechanism 6 do not protrude from holding face 33. Therefore, even if arrangement directional moving section 2 moves slightly in the arrangement direction and the position of attachment/detachment directional moving section 32 is finely adjusted, there is no risk of damage to tape feeder 8. If direct operation member 61 and chuck 55 protrude from holding face 33, it is necessary to retract attachment/detachment directional moving section 32 once before arrangement directional moving section 2 moves, causing the operation to become complicated and inefficient.

Next, control section 79 starts stepping motor 71. As a result, second gear 76 and swing member 77 start rotating clockwise in Fig. 3, and direct operation member 61 starts advancing in the attachment/detachment direction. As intermediate driving pins 64 of direct operation member 61 advance, slide plate 51 is also biased and starts to advance. Thereafter, slide plate 51 advances to an advanced position in which support pin 38 contacts the rear edge of slide hole 52. As a result, direct operation member 61 and chucks 55 in the closed state both protrude from holding face 33 and enter holding hole 8P.

When direct operation member 61 further advances after slide plate 51 stops at the advanced position, indirect driving protrusions 65 come close to the proximal portions of chucks 55. Thereafter, indirect driving protrusions 65 push and expand the proximal portions of the pair of upper and lower chucks 55 to open chucks 55. As shown in Fig. 5, the upper and lower pair of chucks 55 are then brought into a state in which the bent portions are opened and grip the inside face of holding plate 8N. Fig. 5 is a side view of attachment/detachment directional moving section 32 showing a holding state in which holding mechanism 5 and release mechanism 6 operate. Attachment/detachment directional moving section 32 holds tape feeder 8 using the pair of upper and lower chucks 55 of holding mechanism 5. Note that there may be some backlash between chuck 55 and holding plate 8N in the holding state.

When direct operation member 61 finishes advancing the predetermined operation stroke length, release operation portion 63 pushes release arm 8J forward. As a result, lock section 8C shifts to the release state. Next, attachment/detachment direction driving device 4 retracts attachment/detachment directional moving section 32 holding tape feeder 8. At this juncture, tape feeder 8 slides while protruding strip 88 of the bottom face is guided by slot 314 of bottom plate 313 and is accommodated in the internal space of exchange section 3. Fig. 6 is a perspective view showing a state in which exchange section 3 accommodates tape feeder 8. In Fig. 6, case 31 constituting exchange section 3 is omitted. Alternatively, slot 314 of bottom plate 313 may be omitted from exchange section 3 and tape feeder 8 may be supported by holding section 5 only.

When accommodating tape feeder 8, the attachment/detachment directional moving section 32 horizontally pulls out tape feeder 8 in the attachment/detachment direction. The pulling-out force at this time acts on tape feeder 8 from chuck 55. Since chuck 55 is at the same height as connector 8B, connector 8B is pulled out straight. Therefore, the risk of damage to connector 8B is reduced. Similarly, upper positioning pin 89 and lower positioning pin 8A hardly exert a pulling-out force in an oblique direction, thereby reducing the risk of damage. In addition, it is sufficient to use a small amount of pulling-out force.

Thereafter, exchange section 3 is driven to the front face of any of feeder storage device 96, component supply section 9A, and spare feeder storage section 9B. Exchange section 3 can store or install accommodated tape feeder 8 in any of the slots. The storage operation and the installation operation of tape feeder 8 are performed in substantially reverse order of the holding operation described above.

With exchange device 1 of the embodiment, since holding mechanism 5 and release mechanism 6 are driven by a shared driving section 7, stepping motor 71 can be shared and used as a common driving source. In addition, since holding mechanism 5 is configured to be indirectly driven by direct operation member 61 of release mechanism 6, the number of constituent components can be reduced as compared with the conventional case. Due to these synergistic effects, the configuration of the driving section can be simplified, and exchange device 1 of low cost can be provided as compared to the prior art in which separate driving sections are provided for holding mechanism 5 and release mechanism 6, respectively.

### 5. Applications and modifications of the embodiment

Exchange device 1 of the embodiment includes two sets of attachment/detachment directional moving sections 32 and attachment/detachment direction driving devices 4; and four sets of holding mechanisms 5, release mechanisms 6, shared driving sections 7, and control sections 79; but each exchange device 1 may be configured with one of each of the above-mentioned devices. Instead of chuck 55 that grips tape feeder 8 in holding mechanism 5, a hook that hooks and pulls out tape feeder 8, an electromagnet that attracts tape feeder 8 by magnetic force, or the like may be used. Further, direct operation member 61 directly driven by shared driving section 7 may perform the holding operation of tape feeder 8, and the indirect drive member driven by direct operation member 61 may perform the release operation of lock section 8C.

As an exchange device not including lifting/lowering driving section 26, tape feeder 8 may be made to be exchanged only between component supplying section 9A and feeder storage device 96. Furthermore, tape feeder 8 may be configured so that tape reel TR can be taken out from the rear, and exchange device 1 may be made to exchange only tape reel TR as an exchangeable element. Various other applications and modifications of the present embodiment are possible within the limits of the appended claims.

### REFERENCE SIGNS LIST

1: Exchange device, 2: Arrangement directional moving section, 20: Arrangement direction driving device, 26: Lifting/lowering driving section, 3: Exchange section, 32: Attachment/detachment directional moving section, 33: Holding face, 4: Attachment/detachment direction driving device, 5: Holding mechanism, 51: Slide plate, 55: Chuck, 6: release mechanism, 61: Direct operation member, 63: Release operation portion, 64: Intermediate driving pin, 65: Indirect driving protrusion, 67: Manual lever, 6A: Reference position sensor, 6B: Holding position sensor, 7: Shared driving section, 71: Stepping motor, 73: First gear, 76: Second gear, 77: Swing member, 79: Control section, 8: Tape feeder, 8C: Lock section, 9: Component mounting system, 93: First component mounting device, 94: Second component mounting device, 95: Third component mounting device, 96: Feeder storage device, 9A: Component supply section, 9B: Spare feeder storage section

## Claims

1. A component mounting device comprising a component supply section (9A) and an exchange device (1) configured to exchange an exchangeable element (8) detachably installed in the component supply section (9A) of the component mounting device, the component supply section (9A) in which the exchangeable elements (8), each of which including at least a component container (TR) accommodating multiple components, are arranged in an arrangement direction, the exchange device (1) comprising:
an arrangement directional moving section (2) configured to move with respect to the component mounting device (93, 94, 95) in the arrangement direction;
an attachment/detachment directional moving section (32), being provided in the arrangement directional moving section (2), which is configured to move in an attachment/detachment direction of the exchangeable element (8);
a holding mechanism (5), being provided in the attachment/detachment directional moving section (32), which is configured to hold the exchangeable element (8);
a release mechanism (6), being provided in the attachment/detachment directional moving section (32), which is configured to release a lock section (8C) preventing detachment of the exchangeable element (8) installed in the component supply section (9A);
**characterized in that:**
a shared driving section (7), being provided in the attachment/detachment directional moving section (32), which is configured to operate the holding mechanism (5) and the release mechanism (6), wherein
the attachment/detachment directional moving section (32) includes a direct operation member (61) and an indirect operation member (55), wherein the direct operation member (61) is directly driven by the shared driving section (7) and linearly moves in the attachment/detachment direction is configured to perform one of a holding operation of the exchangeable element (8) and a release operation of the lock section (8C) in addition to operating the indirect operation member (55), and
the indirect operation member (55) moves in a direction other than the attachment/detachment direction and is configured to perform the other of the holding operation of the exchangeable element (8) and the release operation of the lock section (8C).

2. The component mounting device (1) of claim 1, wherein
the direct operation member (61) has a release operation portion (63) at the tip in the attachment/detachment direction configured to release the lock section (8C), and further has, on the side surface, an indirect driving section (65) configured to operate the indirect operation member (55) included in the holding mechanism (5).

3. The component mounting device (1) of claim 1 or 2, wherein
the direct operation member (61) has a release operation portion (63) at the tip in the attachment/detachment direction configured to release the lock section (8C), and further has an intermediate driving section (64) configured to operate the holding mechanism (5) in the attachment/detachment direction.

4. The component mounting device (1) of any one of claims 1 to 3, wherein
the indirect operation member (55) consists of multiple chucks (55) arranged symmetrically with respect to the direct operation member (61), the multiple chucks (55) being configured to grip the exchangeable element (8) by opening and closing.

5. The component mounting device (1) of any one of claims 1 to 4, further comprising:
a position sensor (6A) configured to detect the position where the direct operation member (61) operates; and
a control section (79) configured to control the shared driving section (7) based on the detection result of the position sensor (6A).

6. The component mounting device (1) of any one of claims 1 to 5, wherein
the direct operation member (61) has a manual lever (67) configured to enable manual operation.

7. The component mounting device (1) of any one of claims 1 to 6, wherein
the exchangeable element (8) has, at a predetermined height, at least one of a positioning member defining a positional relationship with the component mounting device (93, 94, 95) and a connector (8B) for making an electrical connection with the component mounting device (93, 94, 95); and
the holding mechanism (5) holds a portion of the exchangeable element (8) at the predetermined height.

8. The component mounting device (1) of any one of claims 1 to 7, wherein
the holding mechanism (5) has a holding face (33) configured to come in contact with the exchangeable element (8); and
the holding mechanism (5) and the release mechanism (6) do not protrude from the holding face (33) in an initial state in which they do not operate.

9. The component mounting device (1) of any one of claims 1 to 8, wherein
the exchangeable element (8) is a component supply device (8) or the component container (TR), the component supply device (8) being configured to supply the component.

## Patentansprüche

1. Eine Bauteilmontagevorrichtung mit einem Bauteilzuführabschnitt (9A) und einer Wechselvorrichtung (1), die zum Wechsel eines in dem Bauteilzuführabschnitt (9A) der Bauteilmontagevorrichtung lösbar eingebauten Wechselelements (8) ausgebildet ist, wobei in dem Bauteilzuführabschnitt (9A) die Wechselelemente (8), die jeweils mindestens einen mehrere Bauteile aufnehmenden Bauteilbehälter (TR) aufweisen, in einer Anordnungsrichtung angeordnet sind, wobei die Austauschvorrichtung (1) umfasst:
einen in Anordnungsrichtung beweglichen Abschnitt (2), der konfiguriert ist sich in Bezug auf die Bauteilmontagevorrichtung (93, 94, 95) in der Anordnungsrichtung zu bewegen;
einen in Anbringungs-/Löserichtung beweglichen Abschnitt (32), der in dem in Anordnungsrichtung beweglichen Abschnitt (2) angeordnet ist und der konfiguriert ist sich in einer Anbringungs-/Löserichtung des Wechselelements (8) zu bewegen;
einen Haltemechanismus (5), der in dem in Anbringungs-/Löserichtung beweglichen Abschnitt (32) angeordnet ist und konfiguriert ist das Wechselelement (8) zu halten,
einen Freigabemechanismus (6), der in dem in Anbringungs-/Löserichtung beweglichen Abschnitt (32) angeordnet ist, der konfiguriert ist einen Verriegelungsabschnitt (8C) freizugeben, der das Lösen des Wechselelements (8) verhindert, das in dem Bauteilzuführabschnitt (9A) installiert ist;
**gekennzeichnet durch:**
einen gemeinsamen Antriebsabschnitt (7), der in dem in Anbringungs-/Löserichtung beweglichen Abschnitt (32) angeordnet ist, der konfiguriert ist den Haltemechanismus (5) und den Freigabemechanismus (6) zu betätigen, wobei
der in Anbringungs-/Löserichtung bewegliche Abschnitt (32) ein direktes Betätigungselement (61) und ein indirektes Betätigungselement (55) enthält, wobei das direkte Betätigungselement (61) direkt durch den gemeinsamen Antriebsabschnitt (7) angetrieben wird und sich linear in der Anbringungs-/Löserichtung bewegt und konfiguriert ist zusätzlich zur Betätigung des indirekten Betätigungselements (55) entweder einen Haltevorgang des Wechselelements (8) oder einen Freigabevorgang des Verriegelungsabschnitts (8C) durchzuführen, und
das indirekte Betätigungselement (55) sich in eine andere Richtung als die Anbringungs-/Löserichtung bewegt und konfiguriert ist entweder den Haltevorgang des Wechselelements (8) oder den Freigabevorgang des Verriegelungsabschnitts (8C) auszuführen.

2. Die Bauteilmontagevorrichtung (1) gemäß Anspruch 1, wobei
das direkte Betätigungselement (61) einen Freigabebetätigungsabschnitt (63) an der Spitze in der Anbringungs-/Löserichtung aufweist, der konfiguriert ist den Verriegelungsabschnitt (8C) freizugeben, und ferner an der Seitenfläche einen indirekten Antriebsabschnitt (65) aufweist, der konfiguriert ist das in dem Haltemechanismus (5) enthaltene indirekte Betätigungselement (55) zu betätigen.

3. Die Bauteilmontagevorrichtung (1) gemäß Anspruch 1 oder 2, wobei
das direkte Betätigungselement (61) einen Freigabebetätigungsabschnitt (63) an der Spitze in der Anbringungs-/Löserichtung aufweist, der konfiguriert ist den Verriegelungsabschnitt (8C) freizugeben, und ferner einen Zwischenantriebsabschnitt (64) aufweist, der konfiguriert ist den Haltemechanismus (5) in der Anbringungs-/Löserichtung zu betätigen.

4. Die Bauteilmontagevorrichtung (1) gemäß einem der Ansprüche 1 bis 3, wobei
das indirekte Betätigungselement (55) aus mehreren Spannvorrichtungen (55) besteht, die symmetrisch in Bezug auf das direkte Betätigungselement (61) angeordnet sind, wobei die mehreren Spannvorrichtungen (55) konfiguriert sind das Wechselelement (8) durch Öffnen und Schließen zu greifen.

5. Die Bauteilmontagevorrichtung (1) gemäß einem der Ansprüche 1 bis 4, des Weiteren umfassend:
einen Positionssensor (6A), der konfiguriert ist die Position zu erfassen, in der das direkte Betätigungselement (61) arbeitet; und
einen Steuerabschnitt (79), der konfiguriert ist den gemeinsamen Antriebsabschnitt (7) basierend auf dem Erfassungsergebnis des Positionssensors (6A) zu steuern.

6. Die Bauteilmontagevorrichtung (1) gemäß einem der Ansprüche 1 bis 5, wobei
das direkte Betätigungselement (61) einen manuellen Hebel (67) aufweist, der konfiguriert ist eine manuelle Betätigung zu ermöglichen.

7. Die Bauteilmontagevorrichtung (1) gemäß einem der Ansprüche 1 bis 6, wobei
das Wechselelement (8) in einer vorbestimmten Höhe mindestens eines von einem Positionierungselement, das eine Positionsbeziehung mit der Bauteilmontagevorrichtung (93, 94, 95) definiert, und einem Verbinder (8B) zum Herstellen einer elektrischen Verbindung mit der Bauteilmontagevorrichtung (93, 94, 95) aufweist; und
der Haltemechanismus (5) einen Teil des Wechselelements (8) in der vorbestimmten Höhe hält.

8. Die Bauteilmontagevorrichtung (1) gemäß einem der Ansprüche 1 bis 7, wobei
der Haltemechanismus (5) eine Haltefläche (33) aufweist, die so gestaltet ist, dass sie mit dem Wechselelement (8) in Kontakt kommt; und
der Haltemechanismus (5) und der Freigabemechanismus (6) in einem Anfangszustand, in dem sie nicht arbeiten, nicht über die Haltefläche (33) hinausragen.

9. Die Bauteilmontagevorrichtung (1) gemäß einem der Ansprüche 1 bis 8, wobei
das Wechselelement (8) eine Bauteilzuführeinrichtung (8) oder der Bauteilbehälter (TR) ist, wobei die Bauteilzuführeinrichtung (8) zum Zuführen des Bauteils ausgebildet ist.

## Revendications

1. Dispositif de montage de composants comprenant une section d'alimentation en composants (9A) et un dispositif d'échange (1) configuré pour échanger un élément échangeable (8) installé de manière amovible dans la section d'alimentation en composants (9A) du dispositif de montage de composants, dans laquelle section d'alimentation en composants (9A) les éléments échangeables (8), dont chacun comprend au moins un conteneur de composants (TR) logeant de multiples composants, sont agencés dans une direction d'agencement, le dispositif d'échange (1) comprenant :
une section de déplacement directionnel d'agencement (2) configurée pour se déplacer par rapport au dispositif de montage de composants (93, 94, 95) dans la direction d'agencement ;
une section de déplacement directionnel de fixation/détachement (32), prévue dans la section de déplacement directionnel d'agencement (2), qui est configurée pour se déplacer dans une direction de fixation/détachement de l'élément échangeable (8) ;
un mécanisme de maintien (5), prévu dans la section de déplacement directionnel de fixation/détachement (32), qui est configuré pour maintenir l'élément échangeable (8) ;
un mécanisme de libération (6), prévu dans la section de déplacement directionnel de fixation/détachement (32), qui est configuré pour libérer une section de verrouillage (8C) empêchant le détachement de l'élément échangeable (8) installé dans la section d'alimentation en composants (9A) ;
**caractérisé en ce que** :
une section d'entraînement partagée (7), prévue dans la section de déplacement directionnel de fixation/détachement (32), qui est configurée pour actionner le mécanisme de maintien (5) et le mécanisme de libération (6), dans lequel
la section de déplacement directionnel de fixation/détachement (32) comprend un organe d'actionnement direct (61) et un organe d'actionnement indirect (55), où l'organe d'actionnement direct (61) est directement entraîné par la section d'entraînement partagée (7), se déplace linéairement dans la direction de fixation/détachement et est configuré pour effectuer l'une parmi une opération de maintien de l'élément échangeable (8) et une opération de libération de la section de verrouillage (8C) en plus d'actionner l'organe d'actionnement indirect (55), et
l'organe d'actionnement indirect (55) se déplace dans une direction autre que la direction de fixation/détachement et est configuré pour effectuer l'autre parmi l'opération de maintien de l'élément échangeable (8) et l'opération de libération de la section de verrouillage (8C).

2. Dispositif de montage de composants (1) de la revendication 1, dans lequel
l'organe d'actionnement direct (61) a une partie d'actionnement de libération (63) au niveau de la pointe dans la direction de fixation/détachement configurée pour libérer la section de verrouillage (8C), et a en outre, sur la surface latérale, une section d'entraînement indirect (65) configurée pour actionner l'organe d'actionnement indirect (55) inclus dans le mécanisme de maintien (5).

3. Dispositif de montage de composants (1) de la revendication 1 ou 2, dans lequel
l'organe d'actionnement direct (61) a une partie d'actionnement de libération (63) au niveau de la pointe dans la direction de fixation/détachement configurée pour libérer la section de verrouillage (8C), et a en outre une section d'entraînement intermédiaire (64) configurée pour actionner le mécanisme de maintien (5) dans la direction de fixation/détachement.

4. Dispositif de montage de composants (1) de l'une quelconque des revendications 1 à 3, dans lequel
l'organe d'actionnement indirect (55) est constitué de multiples mandrins (55) agencés symétriquement par rapport à l'organe d'actionnement direct (61), les multiples mandrins (55) étant configurés pour saisir l'élément échangeable (8) par ouverture et fermeture.

5. Dispositif de montage de composants (1) de l'une quelconque des revendications 1 à 4, comprenant en outre :
un capteur de position (6A) configuré pour détecter la position où l'organe d'actionnement direct (61) fonctionne ; et
une section de commande (79) configurée pour commander la section d'entraînement partagée (7) sur la base du résultat de détection du capteur de position (6A).

6. Dispositif de montage de composants (1) de l'une quelconque des revendications 1 à 5, dans lequel
l'organe d'actionnement direct (61) a un levier manuel (67) configuré pour permettre un actionnement manuel.

7. Dispositif de montage de composants (1) de l'une quelconque des revendications 1 à 6, dans lequel
l'élément échangeable (8) a, à une hauteur prédéterminée, au moins l'un parmi un organe de positionnement définissant une relation de position avec le dispositif de montage de composants (93, 94, 95) et un connecteur (8B) pour établir une connexion électrique avec le dispositif de montage de composants (93, 94, 95) ; et
le mécanisme de maintien (5) maintient une partie de l'élément échangeable (8) à la hauteur prédéterminée.

8. Dispositif de montage de composants (1) de l'une quelconque des revendications 1 à 7, dans lequel
le mécanisme de maintien (5) présente une face de maintien (33) configurée pour venir en contact avec l'élément échangeable (8) ; et
le mécanisme de maintien (5) et le mécanisme de libération (6) ne dépassent pas de la face de maintien (33) dans un état initial dans lequel ils ne fonctionnent pas.

9. Dispositif de montage de composants (1) de l'une quelconque des revendications 1 à 8, dans lequel
l'élément échangeable (8) est un dispositif d'alimentation en composants (8) ou le conteneur de composants (TR), le dispositif d'alimentation en composants (8) étant configuré pour fournir le composant.
